# EUROPEAN PATENT SPECIFICATION

(11) **EP 3 534 397 B1**
(45) Date of publication and mention of the grant of the patent: **23.02.2022**
(21) Application number: 17865648.4
(22) Date of filing: 19.10.2017
(51) Int. Cl.: H01L 23/29, H01L 23/31, H01L 23/58, H01L 25/07, H01L 25/18, H01L 23/62

(54) **RESIN-SEALED SEMICONDUCTOR DEVICE**
HARZVERSIEGELTES HALBLEITERBAUELEMENT
DISPOSITIF À SEMI-CONDUCTEURS SCELLÉ À LA RÉSINE

(30) Priority: 26.10.2016 JP 2016209431
(43) Date of publication of application: 04.09.2019
(73) Proprietor: Mitsubishi Electric Corporation, Chiyoda-ku Tokyo 100-8310 (JP)
(72) Inventor: MITSUI, Takao, Tokyo 100-8310 (JP); MIYAMOTO, Teruo, Tokyo 100-8310 (JP); KATO, Masaki, Tokyo 100-8310 (JP); KASHIHARA, Toshiaki, Tokyo 100-8310 (JP); SHIRAKATA, Yuji, Tokyo 100-8310 (JP); FUJII, Kenta, Tokyo 100-8310 (JP)
(74) Representative: Hoffmann Eitle
(86) International application number: PCT/JP2017/037865
(87) International publication number: WO 2018/079409

(56) References cited:
- EP-A2- 0 282 025
- EP-A2- 0 364 981
- DE-A1- 4 433 503
- JP-A- H08 321 578
- JP-A- 2008 235 502
- JP-A- 2015 185 702
- JP-U- S5 692 347
- JP-U- S6 214 935
- US-A- 4 169 271
- US-A1- 2001 048 148
- US-A1- 2008 284 557

## Description

### Technical Field

The present invention relates to a resin-sealed semiconductor device to be applied to, for example, an automobile, and more particularly, to a resin-sealed semiconductor device in which a short-circuit current generated by a short-circuit fault of a component is cut off.

### Background Art

In recent years, motor-driven vehicles such as hybrid automobiles and electric automobiles are actively being developed in the automotive industry. An inverter device for motor drive, which is configured to drive a motor, uses a battery as a power source to supply a high-voltage drive power to a motor drive circuit. A resin-sealed power semiconductor device is used in the inverter device for motor drive, and the importance of resin-sealed semiconductor devices as a key device is ever increasing in the field of power electronics.

A power semiconductor element used in the inverter device for motor drive is sealed with resin along with other components. In this type of resin-sealed semiconductor device, a short-circuit current flows in an excessive amount when a short-circuit fault occurs in a smoothing capacitor or other electronic parts of the power semiconductor element or of a snubber circuit while power is supplied from the battery. For instance, when upper and lower arms of an inverter are short-circuited by malfunction of a gate drive circuit in an inverter control circuit, an overcurrent flows into the power semiconductor element and causes a short-circuit fault.

When a relay for joining the battery and the motor drive circuit is connected, or the connection is continued, in the short-circuited state, a large current causes the resin-sealed semiconductor device to emit smoke and ignite. Another possible consequence is damage to the battery connected to the inverter device for motor drive from an overcurrent that exceeds the rated current.

The usual way to avoid such situation is to cut off an overcurrent by quickly controlling the switching of the power semiconductor element when the overcurrent is detected by a sensor configured to detect an overcurrent. However, it also has merits to prevent the smoking and other failures described above more reliably by taking further measures to deal with unforeseen situations.

To give a specific example, an overcurrent flowing between the inverter device for motor drive and the battery can be blocked by a fuse for cutting off an overcurrent, which is inserted between the power semiconductor device and the battery. A chip-type overcurrent cutting fuse, however, is very expensive. Thus, there has been required overcurrent cutting means that is simple but capable of cutting off a possible flow of overcurrent into the battery without fail when a short-circuit fault occurs in the power semiconductor element.

One method of providing a resin-sealed semiconductor device having a fuse function uses a thin metal wire for joining the power semiconductor element to an external terminal as a fuse. The thin metal wire is melted by heat generated during a flow of an overcurrent, and eventually breaks as a result of the migration of the metal to the surrounding space. However, when the thin metal wire is sealed with resin along with the power semiconductor element, there is no space to which the metal from the thin metal wire melted by a flow of an overcurrent can migrate, and the overcurrent accordingly continues to flow in the thin metal wire for a long period of time.

In order to address this, there has been proposed a semiconductor device in which a copper wire for electric connection between an electrode of a power semiconductor element and an external connection terminal is provided as a power lead, and the power lead is partially covered with silicone gel to be melted down or blocked (see JP 2009-218275 A, for example).

Another document is EP 0 282 025 A2 which refers to a semiconductor device with fuse function. The device includes a radiation plate with conductive patterns formed on an insulating layer on one surface of the radiation plate, semiconductor elements fixed on and connected to the conductive patterns, external terminals connected to the conductive patterns, an outer casing, which is filled with epoxy resin, enclosing the semiconductor elements and the terminals. Part of each of the terminals is exposed to an exterior of the casing. At least one of the terminals may include a hollow fuse, which may be coated with silicone rubber.

EP 0 364 981 A2 shows an overcurrent preventive diode comprising a chip diode sandwiched between respective bonding ends of first and second leads.

DE 44 33 503 A1 refers to a semiconductor chip and a corresponding fabrication method.

A semiconductor device of US 4, 169, 271 A1 comprises a semiconductor chip including a high power consumption portion, an internal lead wire connecting an electrode portion of the semiconductor chip with an external terminal, a soft material adhered to a substantially middle portion of the lead wire and a moulding material for integrally moulding the semiconductor chip.

### Summary of Invention

### Technical Problem

However, the related art has the following problem.

The copper wire having the fuse function is partially covered with silicone gel in the semiconductor device described in JP 2009-218275. The silicone gel in contact with the copper wire is carbonized by heat generated in the copper wire, and, when the layer of the silicone gel is not thick enough, a problem occurs in which the product of the carbonization piles up and has a combustion reaction upon contact with the atmospheric air, thereby causing the resin-sealed semiconductor device to emit smoke and ignite.

The present invention has been made to solve the problem described above, and an object of the present invention is to provide a resin-sealed semiconductor device capable of cutting off an overcurrent without fail and having high resistance against smoking and ignition.

### Solution to Problem

According to the present invention, there is provided a resin-sealed semiconductor device with the features mentioned in claim 1.

### Advantageous Effects of Invention

According to the resin-sealed semiconductor device of one embodiment of the present invention, there are formed the fuse portion formed in the power lead, the first resin sealing portion configured to cover the fuse portion, and the second resin sealing portion configured to block the first resin sealing portion from atmospheric air and to form the molded resin portion.

An overcurrent can be cut off without fail by forming the fuse portion in the power lead. In addition, smoking and ignition can be prevented by covering the fuse portion with the first resin sealing portion and blocking the first resin portion from the atmospheric air with the second resin sealing portion, and thereby suppressing the combustion reaction of the resin.

It is therefore possible to provide the resin-sealed semiconductor device capable of cutting off an overcurrent without fail and having high resistance against smoking and ignition.

### Brief Description of Drawings

FIG. 1 is a plan view for illustrating a resin-sealed semiconductor device according to a first embodiment of the present invention.
FIG. 2 is a sectional view taken along the line A-A of FIG. 1.
FIG. 3 is a sectional view taken along the line B-B of FIG. 1.

### Description of Embodiments

A description is now given of a resin-sealed semiconductor device according to a preferred embodiment of the present invention referring to the accompanying drawings, and throughout the drawings, like or corresponding components are denoted by like reference symbols to describe those components. A component in one drawing and the same component in another drawing are each illustrated in an independent size and on an independent scale.

### First Embodiment

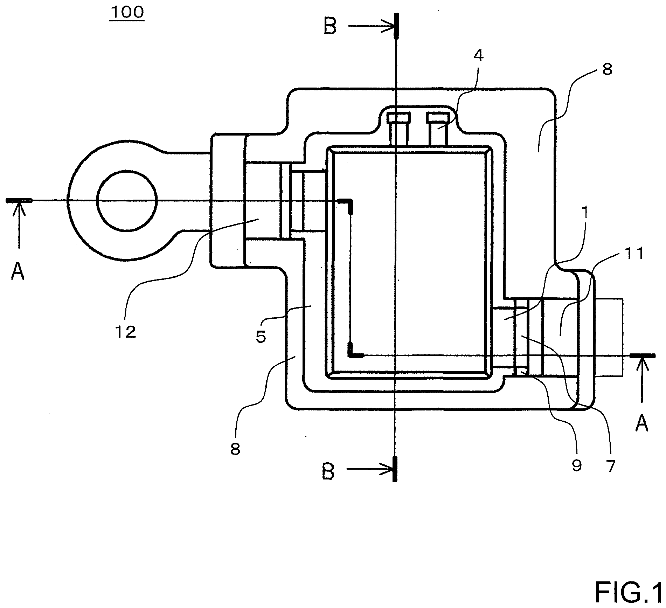

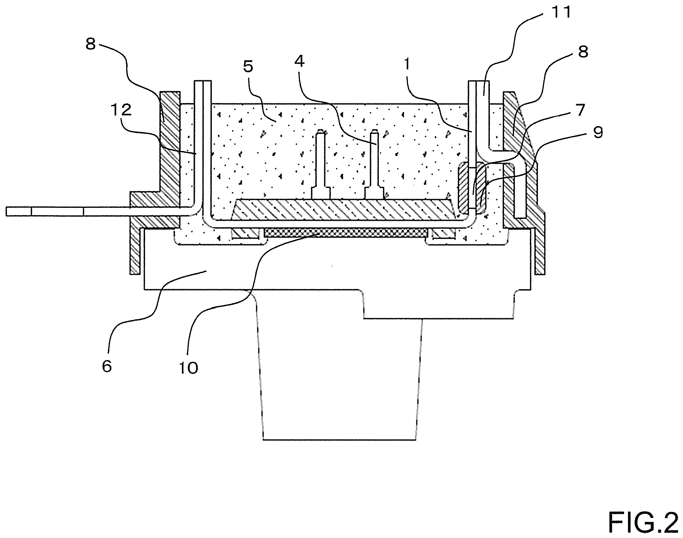

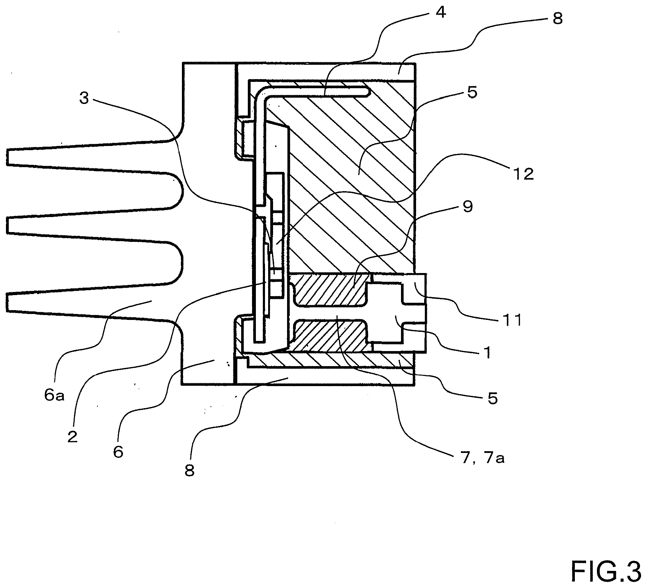

FIG. 1 is a plan view for illustrating a resin-sealed semiconductor device according to a first embodiment of the present invention. FIG. 2 is a sectional view taken along the line A-A of FIG. 1. FIG. 3 is a sectional view taken along the line B-B of FIG. 1.

In FIG. 1 to FIG. 3, a resin-sealed semiconductor device 100 includes an external terminal lead frame 1, which is a power lead, a power semiconductor element 2, a conductive joint material 3, control lead frames 4, a molded resin portion 5, which is a second resin sealing portion, a heat sink 6, a fuse portion 7, an insulating case 8, a first resin sealing portion 9, an insulating sheet 10, an external connection terminal 11, and an inner lead 12.

The power semiconductor element 2 is formed on a face opposite to the heat sink 6. A main electrode of the power semiconductor element 2 is connected to the external terminal lead frame 1 by the joint material 3. The external terminal lead frame 1 is used for input and output, and is fixed to the heat sink 6 by the insulating sheet 10.

The external terminal lead frame 1 is electrically connected, by welding or soldering, to the external connection terminal 11, which is inserted in the insulating case 8. The power semiconductor element 2 and the control lead frames 4 are electrically connected by the inner lead 12 or a bonding wire (not shown).

The power semiconductor element 2 is constituted by a power field-effect transistor (power metal-oxide-semiconductor field-effect transistor: power MOSFET), an insulated gate bipolar transistor (IGBT), or the like.

The above-mentioned elements are used in an inverter device configured to drive a motor or similar electric equipment to control a rated current of several hundred amperes. The conductive joint material 3 is made of solder or the like, and is used to electrically connect and firmly fix the power semiconductor element 2 to the external terminal lead frame 1.

The fuse portion 7 is formed in the external terminal lead frame 1, and is embedded in the first resin sealing portion 9. The first resin sealing portion 9 is formed by application with the use of a dispenser or the like after the power semiconductor element 2 is mounted to the heat sink 6, and after the external terminal lead frame 1 and the external connection terminal 11 are joined. The mounting of a control substrate (not shown) and the cast molding of the molded resin portion 5 are then conducted.

At least a surface of the first resin sealing portion 9 is required to be cured prior to the cast molding of the molded resin portion 5 because curing can be inhibited by accidental mixing of the first resin sealing portion 9 and the molded resin portion 5. It is therefore preferred for the first resin sealing portion 9 to be made of resin that is cured by moisture curing or solvent removal. Another material suitable for the first resin sealing portion 9 is rubber having an elastic coefficient of about several tens MPa, or a similar material, and silicone rubber or silicone gel from which an arc extinguishing effect can be expected is used.

The fuse portion 7 is formed by forming a narrowed portion 7a in the external terminal lead frame 1, and is melted down to cut off the overcurrent when an overcurrent flows into the external terminal lead frame 1. The external terminal lead frame 1 can be formed, though not limited thereto, by performing punching process on a plate made of copper or a copper alloy and having a thickness of from about 0.5 mm to about 1 mm.

The heat sink 6 and the insulating case 8 are arranged so as to wrap around the fuse portion 7, and have the role of molding the molded resin portion 5 by cast molding. A material having an elastic coefficient of several GPa, for example, epoxy resin, is suitable for the molded resin portion 5. Any resin material that has high insulation properties and thermal plasticity, for example, polyphenylene sulfide (PPS), can be used to form the insulating case 8.

The molded resin portion 5 covers the first resin sealing portion 9 so as to expose a peripheral end portion of the external terminal lead frame 1. The insulating case 8 has a main body portion, an opening portion, and a hollow portion. Resin for cast molding is injected from the opening portion of the insulating case 8 to mold the molded resin portion 5 so that the insulating case 8 containing the power semiconductor element 2 and the first resin sealing portion 9 inside is entirely covered.

The molded resin portion 5 is firmly fixed above the heat sink 6 made of metal, with the insulating sheet 10 interposed between the molded resin portion 5 and the heat sink 6. The insulating sheet 10 is inserted between the external terminal lead frame 1 and the heat sink 6 to firmly fix the external terminal lead frame 1 and the heat sink 6. Any material having high heat conductance and high electrical insulation properties, for example, a ceramic sheet, can be used for the insulating sheet 10.

One of the control lead frames 4 is connected to a front-side electrode of the power semiconductor element 2 via the conductive joint material 3, and another of the control lead frames 4 is led out as a control input/output terminal. The molded resin portion 5 can be molded from any thermally curable resin material. An example of a preferred material from which the molded resin portion 5 is molded is epoxy resin in which alumina, a silicon compound, or other substance having high heat conductance is contained as a filler.

The heat sink 6 has the role of dissipating heat that is generated when a current flows in the power semiconductor element 2 sealed in the molded resin portion 5. The heat sink 6 is formed from a material having a heat conductivity of 100 W/m·K or more, for example, aluminum. The molded resin portion 5 is joined directly to a top face of the heat sink 6, and a plurality of cooling fins 6a are arranged on a bottom face of the heat sink 6.

According to the first embodiment of the present invention, an overcurrent is thus cut off without fail by forming the fuse portion 7 in the external terminal lead frame 1, and the resin-sealed semiconductor device can also be prevented from emitting smoke and igniting by covering the fuse portion 7 with the first resin sealing portion 9 and blocking the first resin sealing portion 9 from the atmospheric air, and thereby suppressing the combustion reaction of the resin.

In addition, water infiltration unique to automobiles due to the intake of a splashed snow melting agent can be prevented as well as electric corrosion of the narrowed portion 7a, which is a part of the fuse portion 7 and is small in sectional area, by covering the narrowed portion 7a with the first resin sealing portion 9 and with the molded resin portion 5. The resultant effect is that the fuse portion 7 is not broken even when no overcurrent is generated.

The molded resin portion 5 is formed from epoxy resin in which alumina, a silicon compound, or other substance having high heat conductance is contained as a filler, and is accordingly high in the conductance of heat to the first resin sealing portion 9, which means that heat generated in the fuse portion 7 can be conducted with efficiency to suppress the combustion reaction.

The molded resin portion 5, which has a high elastic coefficient, is arranged around the first resin sealing portion 9, which has a low elastic coefficient, thereby preventing the molded resin portion 5 from developing a crack due to thermal stress applied when the fuse is melted down. This allows the spacing to be kept to a proper distance when the fuse is melted down, thereby ensuring that a current is cut off without fail.

Substance of the fuse scattered by the melting down lands on the first resin sealing portion 9, which has a low elastic coefficient, and the amount of scattered substance that remains in the melted down portion of the fuse is accordingly small. A stable overcurrent cutting effect is obtained as a result. The scattered substance is also prevented from flying to the outside by arranging the molded resin portion 5, which has a high elastic coefficient, around the first resin sealing portion 9, which has a low elastic coefficient.

The molded resin portion 5 is in direct contact with the top face of the heat sink 6, and the plurality of cooling fins 6a are formed on the bottom face of the heat sink 6. This reduces heat generation in the fuse portion 7 and accordingly suppresses the combustion reaction.

As described above, according to the first embodiment, the fuse portion formed in the power lead, the first resin sealing portion configured to cover the fuse portion, and the second resin sealing portion configured to block the first resin sealing portion from atmospheric air and to form the molded resin portion are formed.

An overcurrent can be cut off without fail by forming the fuse portion in the power lead. In addition, smoking and ignition can be prevented by covering the fuse portion with the first resin sealing portion and covering the first resin portion with the second resin sealing portion to block the first resin portion from the atmospheric air, and thereby suppressing the combustion reaction of the resin.

It is therefore possible to provide the resin-sealed semiconductor device capable of cutting off an overcurrent without fail and having high resistance against smoking and ignition.

### Reference Signs List

1 external terminal lead frame (power lead), 2 power semiconductor element, 3 conductive joint material, 4 control lead frame, 5 molded resin portion (second resin sealing portion), 6 heat sink, 6a cooling fin, 7 fuse portion, 7a narrowed portion, 8 insulating case, 9 first resin sealing portion, 10 insulating sheet, 11 external connection terminal, 12 inner lead, 100 resin-sealed semiconductor device

## Claims

1. A resin-sealed semiconductor device (100), which includes a power semiconductor element (2) and a power lead (1) connected to a main electrode of the power semiconductor element, the power semiconductor element being molded with resin, the resin-sealed semiconductor device comprising:
a fuse portion (7) formed by forming a narrowed portion (7a) in the power lead (1);
a first resin sealing portion (9) configured to cover the fuse portion; and
a second resin sealing portion (5) configured to block the first resin sealing portion (9) from atmospheric air, wherein the power lead (1) protrudes from the second resin sealing portion (5),wherein the second resin sealing portion (5) is in direct contact with one face of a heat sink (6), and another face of the heat sink (6) has a plurality of cooling fins (6a) formed thereon,
an insulating case (8) having a main body portion, an opening portion, and a hollow portion,
wherein the second resin sealing portion (5) is molded such that the insulating case (8) containing the power semiconductor element (2) and the first resin sealing portion (9) inside is entirely covered,
and wherein the second resin sealing portion (5) is fixed above the heat sink (6) made of metal, with the insulating sheet inserted between the power lead (1) and the heat sink (6) to fix the power lead (1) and the heat sink (6).

2. The resin-sealed semiconductor device according to claim 1, wherein the second resin sealing portion (5) is higher in heat conductance than the first resin sealing portion (9).

3. The resin-sealed semiconductor device according to claim 1 or 2, wherein the second resin sealing portion (5) is higher in elastic coefficient than the first resin sealing portion (9).

## Patentansprüche

1. Harzversiegelte Halbleitervorrichtung (100), welche ein Leistungshalbleiterbauteil (2) und eine Stromleitung (1) aufweist, die mit einer Hauptelektrode des Leistungshalbleiterbauelement verbunden ist, wobei das Leistungshalbleiterelement mit Harz umformt ist,
wobei die harzversiegelte Halbleitervorrichtung aufweist:
einen Sicherungsabschnitt (7), der gebildet ist, indem in der Stromleitung (1) ein verengter Abschnitt (7a) gebildet wird;
einen ersten Harzversiegelungsabschnitt (9), der eingerichtet ist, den Sicherungsabschnitt zu bedecken; und
einen zweiten Harzversiegelungsabschnitt (5), der eingerichtet ist, den ersten Harzversiegelungsabschnitt (9) vor Umgebungsluft abzuschirmen, wobei die Stromleitung (1) von dem zweiten Harzversiegelungsabschnitt (5) vorsteht, wobei der zweite Harzversiegelungsabschnitt (5) in direktem Kontakt mit einer Fläche eines Kühlkörpers (6) ist und eine andere Fläche des Kühlkörpers (6) eine Vielzahl von daran gebildeten Kühlrippen (6a) aufweist,
ein Isoliergehäuse (8) mit einem Hauptkörperabschnitt, einem Öffnungsabschnitt und einem hohlen Abschnitt,
wobei der zweite Harzversiegelungsabschnitt (5) derart ausgeformt ist, dass das Isoliergehäuse (8), welches in seinem Inneren das Leistungshalbleiterelement (2) und den ersten Harzversiegelungsabschnitt (9) enthält, vollständig bedeckt ist,
und wobei der zweite Harzversiegelungsabschnitt (5) oberhalb des Kühlkörpers (6) aus Metall gefertigt befestigt ist, wobei zwischen der Stromleitung (1) und dem Kühlkörper (6) die Isolierfolie eingefügt ist, um die Stromleitung (1) und den Kühlkörper (6) zu befestigen.

2. Harzversiegelte Halbleitervorrichtung nach Anspruch 1, wobei der zweite Harzversiegelungsabschnitt (5) eine höhere Wärmeleitfähigkeit als der erste Harzversiegelungsabschnitt (9) besitzt.

3. Harzversiegelte Halbleitervorrichtung nach Anspruch 1 oder 2, wobei der zweite Harzversiegelungsabschnitt (5) einen höheren Elastizitätskoeffizienten als der erste Harzversiegelungsabschnitt (9) besitzt.

## Revendications

1. Dispositif semiconducteur scellé par résine (100), qui inclut un élément semiconducteur électrique (2) et un conducteur électrique (1) relié à une électrode principale de l'élément semiconducteur électrique, l'élément semiconducteur électrique étant moulé dans une résine, le dispositif semiconducteur scellé par résine comprenant :
une partie fusible (7) formée par la formation d'une partie rétrécie (7a) dans le conducteur électrique (1) ;
une première partie de scellement par résine (9) configurée pour recouvrir la partie fusible ; et
une seconde partie de scellement par résine (5) configurée pour bloquer la première partie de scellement par résine (9) de l'air atmosphérique, dans lequel le conducteur électrique (1) fait saillie depuis la seconde partie de scellement par résine (5), dans lequel la seconde partie de scellement par résine (5) est en contact direct avec une face d'un dissipateur thermique (6), et une autre face du dissipateur thermique (6) présente une pluralité d'ailettes de refroidissement (6a) formées sur celle-ci,
un boîtier isolant (8) présentant une partie de corps principal, une partie d'ouverture et une partie creuse,
dans lequel la seconde partie de scellement par résine (5) est moulée de sorte que le boîtier isolant (8) contenant l'élément semiconducteur électrique (2) et la première partie de scellement par résine (9) à l'intérieur de celui-ci soit entièrement recouvert,
et dans lequel la seconde partie de scellement par résine (5) est fixée au-dessus du dissipateur thermique (6) constitué de métal, avec la feuille isolante insérée entre le conducteur électrique (1) et le dissipateur thermique (6) pour fixer le conducteur électrique (1) et le dissipateur thermique (6).

2. Dispositif semiconducteur scellé par résine selon la revendication 1, dans lequel la seconde partie de scellement par résine (5) présente une conductance thermique supérieure à celle de la première partie de scellement par résine (9).

3. Dispositif semiconducteur scellé par résine selon la revendication 1 ou 2, dans lequel la seconde partie de scellement par résine (5) présente un coefficient d'élasticité supérieur à celui de la première partie de scellement par résine (9).
